# EUROPÄISCHE PATENTSCHRIFT

(11) **EP 2 183 185 B1**
(45) Veröffentlichungstag und Bekanntmachung des Hinweises auf die Patenterteilung: **10.02.2016**
(21) Anmeldenummer: 08774763.0
(22) Anmeldetag: 04.07.2008
(51) Int. Cl.: B81C 1/00, H01L 21/20, H01L 23/10

(54) **WAFERFÜGEVERFAHREN MIT SINTERSCHRITT, WAFERVERBUND SOWIE CHIP**
WAFER JOINING METHOD, WAFER ASSEMBLAGE, AND CHIP
PROCÉDÉ D'ASSEMBLAGE DE TRANCHES DE SEMI-CONDUCTEUR, TRANCHE DE SEMI-CONDUCTEUR COMPOSITE ET PUCE

(30) Priorität: 31.07.2007 DE 102007035788
(43) Veröffentlichungstag der Anmeldung: 12.05.2010
(73) Patentinhaber: Robert Bosch GmbH, 70442 Stuttgart (DE)
(72) Erfinder: DONIS, Dieter, 70439 Stuttgart (DE); KOENIG, Jens, 71706 Markgroeningen (DE)
(86) Internationale Anmeldenummer: PCT/EP2008/058652
(87) Internationale Veröffentlichungsnummer: WO 2009/015984

(56) Entgegenhaltungen:
- DE-A1- 3 613 215
- PEI-I WANG ET AL: "Low temperature copper-nanorod bonding for 3D integration" ENABLING TECHNOLOGIES FOR 3-D INTEGRATION SYMPOSIUM MATERIALS RESEARCH SOCIETY USA, 2007, Seiten 225-230, XP007907550
- JIN Y ET AL: "MEMS vacuum packaging technology and applications" ELECTRONICS PACKAGING TECHNOLOGY, 2003 5TH CONFERENCE (EPTC 2003) DEC. 10-12, 2003, PISCATAWAY, NJ, USA,IEEE, 10. Dezember 2003 (2003-12-10), Seiten 301-306, XP010687486 ISBN: 978-0-7803-8205-3
- GUO-QUAN LU ET AL: "A lead-free, low-temperature sintering die-attach technique for high-performance and high-temperature packaging" HIGH DENSITY MICROSYSTEM DESIGN AND PACKAGING AND COMPONENT FAILURE AN ALYSIS, 2004. HDP '04. PROCEEDING OF THE SIXTH IEEE CPMT CONFERENCE ON SHANGHAI, CHINA 30 JUNE-3 JULY 2004, PISCATAWAY, NJ, USA,IEEE, US, 30. Juni 2004 (2004-06-30), Seiten 42-46, XP010733589 ISBN: 978-0-7803-8620-4

## Beschreibung

### Stand der Technik

Die Erfindung betrifft ein Verfahren zum Fügen eines ersten Wafers mit mindestens einem zweiten Wafer gemäß dem Oberbegriff des Anspruchs 1, einen Waferverbund gemäß dem Oberbegriff des Anspruchs 14 sowie einen Chip gemäß dem Oberbegriff des Anspruchs 15.

Aus der DE 10 2004 021 258 A1 ist es bekannt, zwei Wafer durch Verlöten aneinander festzulegen. Hierzu wird Lötmittel auf metallische Bondrahmen aufgetragen, die jeweils eine elektronische Schaltung umgeben. Nach dem Inkontaktbringen der zu bondenden Wafer wird das Lötmittel aufgeschmolzen und es entsteht eine feste Lötverbindung zwischen den Wafern. Nachteilig bei dem bekannten Waferbondverfahren ist es, dass sehr breite Bondrahmen verwendet werden müssen, um das während des Lötens verflüssigte Lötmittel aufnehmen zu können. Je nach Anwendungsfall können diese Bondrahmen zwischen 10 und 45 Prozent der resultierenden Chipfläche beanspruchen. Darüber hinaus ist die Temperaturbelastung der elektronischen Bauteile beim Lötprozess hoch, was schlimmstenfalls zu Beschädigungen elektronischer Komponenten führen kann.

Aus der Veröffentlichung von Pei-I Wang et al.: "Low temperature copper-nanorod bonding for 3D integration", ENABLING TECHNOLOGIES FOR 3-D INTEGRATION SYMPOSIUM, MATERIALS RESEARCH SOCIETY USA, 2007, Seiten 225-230, ist ein Verfahren zum Fügen zweier Wafer bekannt, wobei eine Schicht aus Kupfer-Nanostäbchen gesintert wird.

### Offenbarung der Erfindung

### Technische Aufgabe

Der Erfindung liegt daher die Aufgabe zugrunde, ein Füge-Verfahren für Wafer vorzuschlagen, bei dem auf den Wafern lediglich kleine Tabuzonen vorgesehen werden müssen und bei dem die Temperaturbelastung der elektronischen Komponenten auf den Wafern minimiert ist. Ferner besteht die Aufgabe darin, einen entsprechend optimierten Waferverbund aus mindestens zwei Wafern sowie einen aus dem Waferverbund herausgetrennten, entsprechend optimierten Chip vorzuschlagen.

### Technische Lösung

Diese Aufgabe wird hinsichtlich des Verfahrens mit den Merkmalen des Anspruchs 1, hinsichtlich des Waferverbundes mit den Merkmalen des Anspruchs 13 und hinsichtlich des Chips mit den Merkmalen des Anspruchs 14 gelöst. Vorteilhafte Weiterbildungen der Erfindung sind in den Unteransprüchen angegeben. In den Rahmen der Erfindung fallen auch sämtliche Kombinationen aus zumindest zwei von in der Beschreibung, den Ansprüchen und/oder den Figuren offenbarten Merkmalen.

Der Erfindung liegt der Gedanke zugrunde, mindestens zwei Wafer, von denen beispielsweise ein erster Wafer als Sensorwafer mit einer elektronischen Schaltung und ein zweiter Wafer als Kappenwafer zum Verkappen der elektronischen Schaltung des ersten Wafers ausgebildet sein kann, durch einen Sinterprozess zu fügen (bonden). Der Vorteil gegenüber dem bekannten Lötverfahren ist es, dass das zur Anwendung kommende Bondingmaterial sich nicht, zumindest nicht vollständig, verflüssigt, wodurch wesentlich kleinere Tabuzonen, insbesondere Bondrahmen, vorgesehen werden müssen und in der Folge prozentual mehr Fläche auf einem Wafer zum Vorsehen elektronischer Schaltungen genutzt werden kann, so dass in der weiteren Folge mit einem Wafer eine größere Anzahl von Chips hergestellt werden können. Ein weiterer wesentlicher Vorteil des erfindungsgemäßen Verfahrens besteht darin, dass die Temperaturbelastung der elektronischen Komponenten beim Sinterprozess wesentlich geringer ist als bei dem bekannten Lötprozess. Vorzugsweise beträgt die Sintertemperatur dabei weniger als 350°, insbesondere weniger als 300°, bevorzugt weniger als 250°C. Üblicherweise liegt die eigentliche Betriebstemperatur eines aus dem nach dem Konzept der Erfindung ausgebildeten Verfahren resultierenden Chips deutlich über dieser Sintertemperatur (Fügetemperatur). Bei dem erfindungsgemäßen Verfahren wird wie folgt vorgegangen: Zunächst wird sinterfähiges Bondingmaterial, insbesondere mit einer Partikelgrößenverteilung aus dem Nanometer- und/oder Mikrometerbereich, auf zumindest einen der zu bondenden Wafer aufgetragen. In einem nächsten Schritt werden die Wafer, insbesondere nach einem zuvorigem Ausrichten relativ zueinander, zusammengeführt, d.h. aufeinander oder aneinander gelegt, und das sinterfähige Bondingmaterial wird erhitzt, so dass ein Sinterprozess resultiert. Unter "Zusammenführen" im Sinne der Erfindung wird nicht zwangsläufig ein unmittelbares Berühren der Wafer verstanden. Vielmehr wird eine Sandwichstruktur mit zwei äußeren Wafern und dazwischen angeordnetem Bondingmaterial erhalten. Dabei liegt es im Rahmen der Erfindung, dass mit der Erwärmung des Sintermaterials bereits vor dem Zusammenführen der zu bondenden Wafer begonnen wird. Alternativ erfolgt die Erhitzung erst nach dem Zusammenführen der Wafer.

Je nach Partikelgrößenverteilung des zur Anwendung kommenden Bondingmaterials kann es notwendig sein, um eine stabile Sinterverbindung zu erhalten, zusätzlich zu der Sintertemperatur, insbesondere von weniger als 350°C, insbesondere weniger als 300°C, bevorzugt weniger als 250°C, einen Anpressdruck auf die Wafer auszuüben. Insbesondere bei einer Partikelgrößenverteilung im Mikrometerbereich kann es vorteilhaft sein, einen Anpressdruck zwischen etwa 15 und 60 MPa, insbesondere zwischen etwa 25 bis 45 MPa, zu erzeugen. Bei einer Partikelgrößenverteilung im Nanometerbereich reichen bereits geringe Drücke von unter 2 MPa, insbesondere von etwa 1 MPa oder darunter, aus, um eine stabile Sinterverbindung zu erzeugen. Je nach Partikelgrößenverteilung ist es sogar denkbar, auf separate Anpressmittel zur Erzeugung eines Anpressdrucks zu verzichten, so dass lediglich das Eigengewicht zumindest eines oberhalb des ersten Wafers angeordneten Wafers zur Erzeugung eines ausreichenden, minimalen Anpressdrucks ausreicht.

Bezüglich der Realisierung der Erwärmung des Bondingmaterials auf Sintertemperatur gibt es unterschiedliche Möglichkeiten. Gemäß einer ersten Alternative werden die mindestens zwei Wafer zusammen mit dem Bondingmaterial in einem Ofenprozess erhitzt, auf eine Temperatur, bei der eine Versinterung des Bondingmaterials stattfindet. Dabei liegt die Sintertemperatur (Fügetemperatur) bevorzugt unterhalb von 350°C, insbesondere unterhalb von 300°C, bevorzugt unterhalb von 250°C. Sollte es notwendig sein, zur Versinterung einen Anpressdruck aufzubringen, so sind vorzugsweise auch die Anpressmittel innerhalb des Sinterofens angeordnet.

Zusätzlich oder vorzugsweise alternativ ist es gemäß einer zweiten Alternative möglich, nicht die gesamten, miteinander zu bondenden Wafer, sondern lediglich lokal das Bondingmaterial gezielt zu erhitzen. Hierfür eignet sich insbesondere Laserstrahlung, vorzugsweise ein Laserscanner. Der Laserstrahl strahlt dabei vorzugsweise durch einen der mindestens zwei zu bondenden Wafer, insbesondere einen Kappenwafer, hindurch, welcher zumindest im wesentlichen transparent für die Laserstrahlung ausgebildet ist. Durch die Verwendung eines Laserscanners können auch komplexe Bonding-materialkonturen (Sinterkonturen) abgefahren werden. Die gezielte, lokale Erhitzung des Bondingmaterials hat gegenüber dem Ofenprozess wesentliche Vorteile. Zum einen erfolgt eine Erwärmung der Wafer nur im eigentlichen Kontaktbereich zu dem Bondingmaterial, so dass Elektronikbauteile geschont werden. Darüber hinaus resultiert eine Zeitersparnis, da im Gegensatz zum Sinterofenprozess kein vergleichsweise langwieriges Aufheizen und Abkühlen notwendig ist. Bevorzugt wird die Erhitzungsdauer und/oder die Laserstrahlintensität derart eingestellt, dass Sintertemperaturen unterhalb von 350°C, vorzugsweise unterhalb von 300°C, oder vorzugsweise unterhalb von 250°C resultieren. Bevorzugt erfolgt der laserunterstützte Erhitzungsprozess erst nach dem Inkontaktbringen der zu bondenden Wafer.

Bevorzugt ist eine Weiterbildung des Verfahrens, gemäß der zumindest der Sinterschritt unter Vakuum erfolgt, insbesondere um hermetisch abgeriegelte Chips erzeugen zu können. Dabei muss die Prozessführung des Sinterprozesses so abgestimmt werden, dass die resultierende Sinterverbindung eine geschlossene unterdruckdichte Porosität aufweist.

Um eine maximale Festigkeit der Bondverbindung zwischen den mindestens zwei Wafern zu realisieren, ist eine Ausführungsform von Vorteil, bei der die Wafer vor dem Auftragen des Bondingmaterials, vorzugsweise zumindest in dem späteren Kontaktbereich zum Bondingmaterial, metallisiert werden, beispielsweise durch eine Nickel/GoldVerbindung und/oder eine Chrom/Gold-Verbindung und/oder eine Chrom/Silber-Verbindung, etc. Bevorzugt erfolgt die Metallisierung in Form von Bondrahmen, die die eigentliche elektronische Schaltung auf zumindest einem der beiden Wafer umschließen.

Mit Vorteil erfolgt das Auftragen des Bondingmaterials (insbesondere ausschließlich) auf metallisierten Bereichen mindestens eines der Wafer, grundsätzlich jedoch immer auf mindestens einen Bondrahmen, der eine an zumindest einem der Wafer ausgebildete elektronische Schaltung und/oder ein mikromechanisches Element umschließt, um in der Folge vollständig von dem Bondingmaterial umschlossene Schaltungen und/oder mikromechanische Elemente, d.h. Chips mit einer umlaufenden Bondverbindung, zu fertigen.

Besonders gute Ergebnisse wurden mit einem Bondingmaterial erzielt welches Silberpartikel enthält. Bevorzugt liegt die Partikelgrößenverteilung der Silberpartikel im Nanometerbereich und der d₅₀-Wert der Partikelgrößenverteilung liegt bei einem ersten, bevorzugten Bondingmaterial zwischen etwa 2 nm und 10 nm und bei einem zweiten, bevorzugten Bondingmaterial zwischen etwa 30 nm und 50 nm. Darüber hinaus ist es möglich, Bondingmaterial einzusetzen, bei dem die Silberpartikel eine Partikelgrößenverteilung im Mikrometerbereich aufweisen. Dabei wurde mit Silberpartikeln mit einem d₅₀-Wert zwischen etwa 2 - 30 µm gute Ergebnisse erzielt. Grundsätzlich gilt: Je größer die Partikel, desto höher ist der benötigte Anpressdruck zum Erzeugen einer Sinterverbindung.

Von besonderem Vorteil ist eine Ausführungsform, bei der das Bondingmaterial neben Silberpartikeln, die vorzugsweise den größten Masseanteil bilden, Zusatzstoffe, wie organisches Material und/oder Glaslot und/oder Goldlot umfasst, insbesondere um eine geschlossene Porosität der Sinterverbindung zu erhalten, um in der Folge vakuumierte Chips erhalten zu können.

Bevorzugt ist eine Ausführungsform, bei der das Bondingmaterial pastös ist, um ein Verlaufen auf einen Bereich des Wafers außerhalb des Bondrahmens zu verhindern. Zusätzlich oder alternativ ist es möglich, dass das Bondingmaterial als insbesondere trockenes Pulver zur Anwendung kommt.

Insbesondere zum Aufbringen von pastösem Bondingmaterial ist es möglich, dieses durch Schablonendruck und/oder Siebdruck und/oder Sprühen und/oder Dispensen aufzubringen. Bevorzugt wird das Bondingmaterial lediglich auf einen von zwei miteinander zu verbindenden Wafern aufgebracht, woraufhin der Wafer ohne Bondingmaterial relativ zu dem insbesondere unten liegenden Wafer ausgerichtet und mit diesem in Kontakt gebracht wird, falls nötig unter Aufbringung eines Anpressdrucks, vorzugsweise unterhalb von 60 MPa.

Das erfindungsgemäße Verfahren eignet sich nicht nur zum Herstellen von verkappten elektronischen Schaltungen und/oder mikromechanischen Elementen mit zwei Wafern. Mit dem erfindungsgemäßen Verfahren können alternativ auch sogenannten Waferstacks, bestehend aus zumindest drei übereinander angeordneten Wafern, hergestellt werden, wobei es bevorzugt ist, dass zumindest zwei der Wafer, beziehungsweise zwei auf unterschiedlichen Wafern angeordnete Schaltungen, durch Durchkontaktieren miteinander elektrisch leitend verbunden sind.

Insbesondere nach dem (zumindest teilsweise) Aushärten des Bondingmaterials werden die gebondeten Wafer in einzelne Chips oder Chipstacks zerteilt. Dies kann durch an sich bekannte Verfahren, wie beispielsweise einen Sägeprozess, erfolgen. Bevorzugt ist eine Trennung der einzelnen Chips, vorzugsweise in einem Bereich außerhalb der Bondrahmen, durch einen lasergestützten Schneid- bzw. Sägeprozess.

Die Erfindung führt auch auf einen Waferverbund aus mindestens zwei Wafern, wobei zwischen den mindestens zwei Wafern eine gesinterte Bondingverbindung vorgesehen ist, die vorzugsweise nach einem zuvor beschriebenen Verfahren hergestellt wurde. Besonders bevorzugt ist eine Ausführungsform des Waferverbundes, bei der das gesinterte Bondingmaterial eine geschlossene Porosität aufweist.

Ferner führt die Erfindung auch auf einen Chip, der vorzugsweise durch Zerteilen eines vorgenannten Waferverbundes hergestellt wurde. Der nach dem Konzept der Erfindung ausgebildete Chip zeichnet sich durch eine gesinterte Bondverbindung zwischen den mindestens zwei Waferebenen des Chips aus. Vorzugsweise umgibt dabei die, insbesondere geschlossenporige, Bondingverbindung die eigentliche elektronische Schaltung und/oder das mikromechanische Element, wobei vorzugsweise von dem rahmenförmigen Bondingmaterial eine Vakuumatmosphäre dicht umschlossen ist.

### Kurze Beschreibung der Zeichnungen

Weitere Vorteile, Merkmale und Einzelheiten der Erfindung ergeben sich aus der Beschreibung bevorzugter Ausführungsformen sowie anhand der Zeichnungen. Diese zeigen in:
- Fig. 1:: ein Ablaufschema des erfindungsgemäßen Verfahrens unter Anwendung eines Sinterofenprozesses,
- Fig. 2:: eine alternative Abfolge des Verfahrens unter Anwendung von Laserstrahlung zur lokalen Erhitzung des Bondingmaterials,
- Fig. 3:: einen Ausschnitt eines von mindestens zwei miteinander zu verbindenden Wafern,
- Fig. 4:: eine alternative Abfolge des Bondingverfahrens zur Herstellung von Waferstacks.

### Ausführungsformen der Erfindung

In den Figuren sind gleiche Bauteile und Bauteile mit der gleichen Funktion mit den gleichen Bezugszeichen gekennzeichnet.

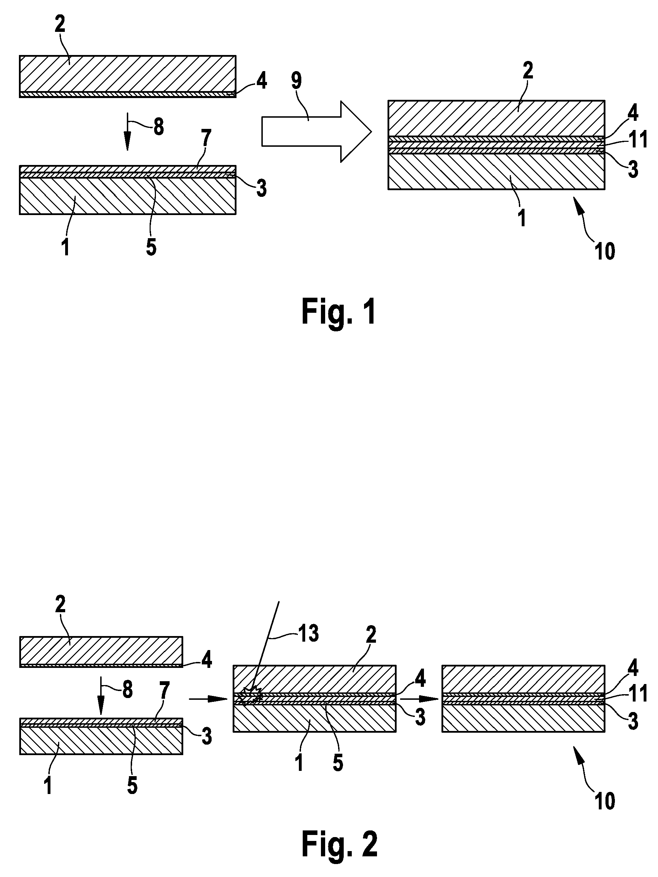

In Fig. 1 ist der Ablauf eines Waferbondverfahrens gezeigt. Zu erkennen ist ein Ausschnitt eines ersten Wafers 1 sowie eines darüber angeordneten zweiten Wafers 2, die sich in einer Vakuumatmosphäre befinden. Zur Anwendung kommende Wafer können beispielsweise aus Silizium und/oder Siliziumoxid und/oder Galliumarsenid und/oder aus sonstigen bekannten Wafermaterialien beschaffen sein.

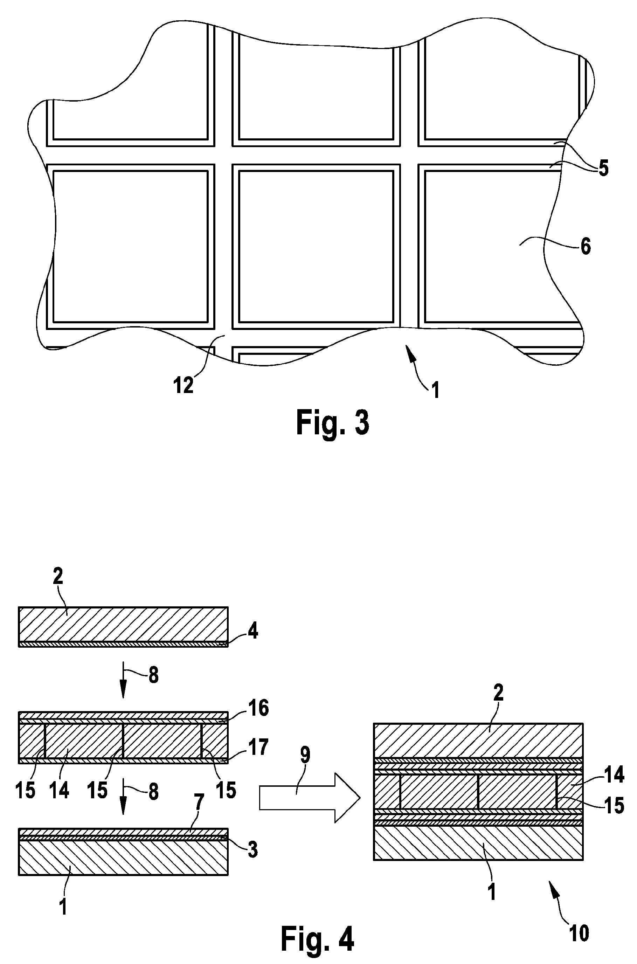

Zu erkennen ist, dass beide Wafer 1, 2 mit jeweils einer Metallisierung 3, 4, beispielsweise aus Nickel/Gold, Chrom/Gold oder Chrom/Silber, versehen sind. Die Metallisierungen 3, 4 sind in der Form von Bondrahmen 5 aufgebracht, wie sie aus Fig. 3 ersichtlich sind. In dem gezeigten Ausführungsbeispiel haben die Bondrahmen eine quadratische Ringkontur, wobei die Bondrahmen 5 bei dem unten angeordneten ersten Wafer 1 eine in Fig. 3 lediglich schematisch angedeutete elektronische Schaltung 6 umgeben. Aus Fig. 3 ist weiterhin ersichtlich, dass eine Vielzahl identischer Schaltungen 6 mit jeweils einem diese umgebenden Bondrahmen 5 auf dem ersten Wafer 1 angeordnet sind. Die nicht gezeigten Bondrahmen des zweiten Wafers 2 haben eine zur Ausformung der Bondrahmen 5 auf dem ersten Wafer 1 formkongruente Ausformung.

Wie aus Fig. 1 ersichtlich ist, wurde auf der Metallisierung (Bondrahmen 5) des ersten Wafers 1 sinterfähiges Bondingmaterial 7, beispielsweise in einem Druckverfahren, aufgebracht.

Wie durch den mit dem Bezugszeichen 8 gekennzeichneten Pfeil angedeutet, werden die beiden Wafer 1, 2 nach dem Aufbringen des Bondingmaterials 7, nach vorheriger Relativausrichtung zusammengeführt, d.h. aufeinander gebracht und in einem Sinterofen erhitzt. Gegebenenfalls werden die beiden Wafer 1, 2 zusätzlich durch nicht gezeigte Anpressmittel aneinander gepresst. Die Sintertemperatur beträgt in dem gezeigten Ausführungsbeispiel etwa 200°C. Der Sinterofenprozess ist durch den mit dem Bezugszeichen 9 gekennzeichneten Pfeil symbolisiert. Nach einer Abkühlphase resultiert der in der rechten Zeichnungshälfte gemäß Fig. 1 gezeigte Waferverbund 10, bestehend aus dem ersten und dem zweiten Wafer 1, 2, zwei Metallisierungen 3, 4 und der dazwischen liegenden Sinterschicht 11 aus gesintertem Bondingmaterial.

Nach dem Abkühlen können aus dem Waferverbund 10 einzelne Chips, beispielsweise durch Laserschneiden oder konventionelles Sägen, herausgeschnitten werden, wobei die Schnittlinien bevorzugt entlang von Bereichen 12 (siehe Fig. 3) zwischen benachbarten Bondrahmen 5 geführt werden.

Aus Fig. 2 ist ein alternatives Waferbondverfahren entnehmbar. Zur Vermeidung von Wiederholungen werden lediglich die Unterschiede zu dem in Fig. 1 gezeigten und zuvor beschriebenen Waferbondverfahren erläutert. Bezüglich der Gemeinsamkeiten wird auf die vorherige Figurenbeschreibung verwiesen.

Nach dem durch den Pfeil 8 gekennzeichneten Inkontaktbringen des ersten und des zweiten Wafers 1, 2 mit eingeschlossenem Bondingmaterial 5 werden nicht die gesamten Wafer 1, 2 erhitzt, sondern lediglich lokal das Bondingmaterial 7. Hierzu wird Laserstrahlung 13 eingesetzt, die in dem gezeigten Ausführungsbeispiel den zweiten, für Laserstrahlung transparenten Wafer 2 durchdringt. Die Kontur der Bondrahmen 5 wird mit Hilfe eines nicht gezeigten Laserscanners abgefahren. Zum Bonden zweier Wafer 1, 2 können auch eine Vielzahl von Laserscannern eingesetzt werden. Ebenso ist es denkbar, die Laserstrahlung durch eine geeignete Optik homogen auf das Bondingmaterial 7 zu richten, also beispielsweise ringquadratische Laserfokusformen zu erzeugen. Aus dem unter Vakuumatmosphäre ausgeführten Verfahren resultiert der in der rechten Zeichnungshälfte gezeigte Waferverbund 10. Der Bondrahmen 5 kann bei dem beschriebenen Verfahren wesentlich dünner ausgebildet werden als bei bekannten Verfahren. Falls es nicht notwendig ist, dass die elektrische Schaltung unter Vakuumatmosphäre angeordnet ist, ist es auch denkbar, die beschriebenen Bondingverfahren unter Normalatmosphäre, insbesondere in einem Reinraum, auszuführen.

In Fig. 4 ist ein zur Herstellung von Waferstacks abgewandeltes Verfahren gezeigt. In dem gezeigten Ausführungsbeispiel wird zwischen dem ersten Wafer 1 und dem zweiten Wafer 2 ein dritter Wafer 14 angeordnet, wobei in dem gezeigten Ausführungsbeispiel der erste Wafer 1 und der dritte Wafer 14 mit einer nicht gezeigten elektronischen Schaltung versehen sind, und wobei die beiden Schaltungen über Durchkontaktierungen 15 miteinander elektrisch leitend verbunden werden.

Bezüglich der Vorgehensweise gibt es unterschiedliche Möglichkeiten. Beispielsweise ist es denkbar, zunächst den ersten Wafer 1 und den dritten Wafer 14 analog zu den Verfahren gemäß Fig. 1 oder 2 miteinander zu verbinden und daraufhin den zweiten Wafer 2 mit den bereits gebondeten anderen Wafern 1, 14 zu bonden. Bevorzugt ist jedoch die in Fig. 4 gezeigte Ausführungsform, bei der alle Wafer 1, 2, 14 gleichzeitig gebondet werden. Hierzu sind sämtliche Wafer 1, 2, 14 mit Metallisierungen 3, 4, 16, 17 in Bondrahmenform versehen. Auf die jeweilige Oberseite des ersten Wafers 1 und des dritten Wafers 14 wird auf die Metallisierungen 3, 16 Bondingmaterial 7 aufgebracht, woraufhin sämtliche Wafer, nach vorherigem Zueinander-Ausrichten, miteinander in Kontakt gebracht werden. Daraufhin findet der mit dem Bezugszeichen 9 gekennzeichnete Sinterprozess, bei Bedarf unter zusätzlicher Anwendung von Anpressdruck, statt, wobei dieser Sinterprozess alternativ im Sinterofen oder laserstrahlunterstützt ausgeführt werden kann. Es resultiert der in Fig. 4 rechts gezeigte Waferverbund (Waferstack), umfassend drei Wafer 1, 2, 14, wobei die beiden unteren Wafer 1, 14 über Durchkontaktierungen 15 miteinander elektrisch leitend verbunden sind. Bei dem obersten, zweiten Wafer 2 handelt es sich lediglich um einen Kappenwafer, der ggf. auf der Außenseite mit Anschlusspunkten versehen sein kann, die zu der Schaltung auf dem dritten Wafer 14 und/oder dem unteren, ersten Wafer 1 durchkontaktiert sind (nicht gezeigt). Mit dem beschriebenen Verfahren können Waferstacks mit einer Vielzahl von Wafern hergestellt werden. Nach dem Bonden der drei Wafer 1, 2, 14 können einzelne Chipstacks mit drei Waferebenen ausgeschnitten werden, vorzugsweise durch einen laserunterstützten Schneidprozess.

## Patentansprüche

1. Verfahren zum Fügen eines ersten Wafers (1) mit mindestens einem zweiten Wafer (2) mit folgenden Schritten:
- Aufbringen eines sinterfähigen Bondingmaterials (7) auf zumindest einen der Wafer (1, 2, 14);
- Zusammenführen der Wafer (1, 2, 14);
- Sintern des Bondingmaterials (7) durch Erhitzen,
**dadurch gekennzeichnet,**
**dass** das Bondingmaterial (7) auf einem Bondrahmen (5) um eine an zumindest einem der Wafer (1, 2, 14) ausgebildete Schaltung (6) aufgetragen wird.

2. Verfahren nach Anspruch 1,
**dadurch gekennzeichnet,**
**dass** die Wafer (1, 2, 14) mit Hilfe von Anpressmitteln mit einem Anpressdruck gegeneinander gepresst werden oder dass der Anpressdruck ohne Anpressmittel, ausschließlich durch das Eigengewicht des mindestens zweiten Wafers (2) oder gegebenenfalls weiterer Wafer (14) und/oder weiteren Bondingmaterials (7) erzeugt wird.

3. Verfahren nach einem der Ansprüche 1 oder 2,
**dadurch gekennzeichnet,**
**dass** das Bondingmaterial (7) zusammen mit den Wafern (1, 2, 14), insbesondere in einem Sinterofen, vorzugsweise auf eine Sintertemperatur unterhalb von 350°C, insbesondere unterhalb von 300°C, bevorzugt unterhalb von 250°C, erhitzt wird.

4. Verfahren nach einem der Ansprüche 1 oder 2,
**dadurch gekennzeichnet,**
**dass** das Bondingmaterial (7) lokal, insbesondere mittels Laserstrahlung (13), bevorzugt mittels mindestens eines Laserscanners, vorzugsweise auf eine Sintertemperatur unterhalb von 250°C erhitzt wird.

5. Verfahren nach einem der vorhergehenden Ansprüche,
**dadurch gekennzeichnet,**
**dass** das Aufbringen des Bondingmaterials (7) und/oder das Inkontaktbringen der Wafer (1, 2, 14) und/oder das Sintern unter Vakuum erfolgt.

6. Verfahren nach einem der vorhergehenden Ansprüche,
**dadurch gekennzeichnet,**
**dass** die Wafer (1, 2, 14), zumindest im späteren Kontaktbereich zu dem Bondingmaterial (7), vorzugsweise in der Form von Bondrahmen (5), vor dem Aufbringen des Bondingmaterials (7) metallisiert werden.

7. Verfahren nach einem der vorhergehenden Ansprüche,
**dadurch gekennzeichnet,**
**dass** Bondingmaterial (7) verwendet wird, welches Silberpartikel, vorzugsweise mit einem d₅₀-Wert von weniger als 300 nm, insbesondere mit einer maximalen Partikelgröße von weniger als 250 nm, vorzugsweise kleiner als 200 nm, insbesondere bevorzugt kleiner als 100 nm, besonders bevorzugt kleiner als 50nm umfasst.

8. Verfahren nach einem der vorhergehenden Ansprüche,
**dadurch gekennzeichnet,**
**dass** den Silberpartikeln mindestens ein Zusatzstoff, insbesondere ein organisches Material, beigemischt ist.

9. Verfahren nach einem der vorhergehenden Ansprüche,
**dadurch gekennzeichnet,**
**dass** pastöses und/oder pulverförmiges Bondingmaterial (7) verwendet wird.

10. Verfahren nach einem der vorhergehenden Ansprüche,
**dadurch gekennzeichnet,**
**dass** das Bondingmaterial (7) durch Schablonendruck, Siebdruck, Sprühen oder Dispensen aufgebracht wird.

11. Verfahren nach einem der vorhergehenden Ansprüche,
**dadurch gekennzeichnet,**
**dass** mehr als zwei Wafer zu einem Waferstack (10) miteinander durch Sintern gebondet werden.

12. Verfahren nach einem der vorhergehenden Ansprüche,
**dadurch gekennzeichnet,**
**dass** die gefügten Wafer (1, 2, 14) in einzelne verkappte Chips, insbesondere mikromechanische Sensorchips, oder Chipstacks zerteilt, insbesondere laserstrahlgeschnitten oder gesägt, werden.

13. Waferverbund, insbesondere hergestellt nach einem Verfahren nach einem der vorhergehenden Ansprüche, umfassend mindestens zwei miteinander gefügte Wafer (1, 2, 14),
wobei die Wafer (1, 2, 14) über zwischen den Wafern angeordnetes, gesintertes Bondingmaterial (7) aneinander festgelegt sind,
**dadurch gekennzeichnet,**
**dass** sich das Bondingmaterial (7) auf einem Bondrahmen (5) um eine an zumindest einem der Wafer (1, 2, 14) ausgebildete Schaltung (6) befindet.

14. Chip, insbesondere Sensorchip, vorzugsweise hergestellt nach einem Verfahren nach einem der Ansprüche 1 bis 12, umfassend mindestens zwei Wafermaterialebenen, wobei die Wafermaterialebenen über zwischen den Wafermaterialebenen angeordnetes, gesintertes Bondingmaterial (7) aneinander festgelegt sind,
**dadurch gekennzeichnet,**
**dass** sich das Bondingmaterial (7) auf einem Bondrahmen (5) um eine an zumindest einem der Wafermaterialebenen ausgebildete Schaltung (6) befindet.

## Claims

1. Method for joining a first wafer (1) to at least one second wafer (2), with the following steps:
- applying a sinterable bonding material (7) to at least one of the wafers (1, 2, 14);
- joining the wafers (1, 2, 14) together;
- sintering the bonding material (7) by heating,
**characterized**
**in that** the bonding material (7) is applied on a bonding frame (5) around a circuit (6) formed on at least one of the wafers (1, 2, 14).

2. Method according to Claim 1,
**characterized**
**in that** the wafers (1, 2, 14) are pressed against one another by using pressing means to apply a pressing pressure or in that the pressing pressure is produced without pressing means, exclusively by the weight of the at least one second wafer (2) or possibly further wafers (14) and/or further bonding material (7).

3. Method according to either of Claims 1 and 2,
**characterized**
**in that** the bonding material (7) is heated together with the wafers (1, 2, 14), in particular in a sintering oven, preferably to a sintering temperature below 350°C, in particular below 300°C, with preference below 250°C.

4. Method according to either of Claims 1 and 2,
**characterized**
**in that** the bonding material (7) is heated locally, in particular by means of laser radiation (13), with preference by means of at least one laser scanner, preferably to a sintering temperature below 250°C.

5. Method according to one of the preceding claims,
**characterized**
**in that** the bonding material (7) is applied and/or the wafers (1, 2, 14) are brought into contact and/or the sintering is performed in a vacuum.

6. Method according to one of the preceding claims,
**characterized**
**in that** the wafers (1, 2, 14) are metallized, at least in the subsequent contact region for the bonding material (7), preferably in the form of bonding frames (5), before the bonding material (7) is applied.

7. Method according to one of the preceding claims,
**characterized**
**in that** bonding material (7) which comprises silver particles, preferably with a d₅₀ value of less than 300 nm, in particular with a maximum particle size of less than 250 nm, preferably less than 200 nm, in particular with preference less than 100 nm, particularly with preference less than 50 nm, is used.

8. Method according to one of the preceding claims,
**characterized**
**in that** at least one additive, in particular an organic material, is admixed with the silver particles.

9. Method according to one of the preceding claims,
**characterized**
**in that** pasty and/or powdery bonding material (7) is used.

10. Method according to one of the preceding claims,
**characterized**
**in that** the bonding material (7) is applied by stencil printing, screen printing, spraying or dispensing.

11. Method according to one of the preceding claims,
**characterized**
**in that** more than two wafers are bonded to one another by sintering to form a wafer stack (10).

12. Method according to one of the preceding claims,
**characterized**
**in that** the joined wafers (1, 2, 14) are divided up, in particular cut by a laser beam or sawn, into individual capped chips, in particular micromechanical sensor chips, or chip stacks.

13. Wafer assemblage, in particular produced by a method according to one of the preceding claims, comprising at least two wafers (1, 2, 14) joined to one another,
the wafers (1, 2, 14) being fixed to one another by sintered bonding material (7) arranged between the wafers,
**characterized**
**in that** the bonding material (7) is on a bonding frame (5) around a circuit (6) formed on at least one of the wafers (1, 2, 14).

14. Chip, in particular a sensor chip, preferably produced by a method according to one of Claims 1 to 12, comprising at least two wafer material levels, the wafer material levels being fixed to one another by sintered bonding material (7) arranged between the wafer material levels,
**characterized**
**in that** the bonding material (7) is on a bonding frame (5) around a circuit (6) formed on at least one of the wafer material levels.

## Revendications

1. Procédé d'assemblage d'une première tranche (1) avec au moins une deuxième tranche (2), comprenant les étapes suivantes:
- déposer un matériau de liaison frittable (7) sur au moins une des tranches (1, 2, 14);
- assemblage des tranches (1, 2, 14);
- frittage du matériau de liaison (7) par chauffage, **caractérisé en ce que** l'on dépose le matériau de liaison (7) sur un cadre de liaison (5) autour d'un circuit (6) formé sur au moins une des tranches (1, 2, 14).

2. Procédé selon la revendication 1, **caractérisé en ce que** l'on presse les tranches (1, 2, 14) l'une contre l'autre avec une pression d'application à l'aide de moyens de pression ou **en ce que** l'on produit la pression d'application sans moyens de pression, exclusivement par le poids propre de ladite au moins une deuxième tranche (2) ou éventuellement d'autres tranches (14) et/ou d'autres matériaux de liaison (7).

3. Procédé selon l'une des revendications 1 ou 2, **caractérisé en ce que** l'on chauffe le matériau de liaison (7) en même temps que les tranches (1, 2, 14), en particulier dans un four de frittage, de préférence à une température de frittage inférieure à 350°C, en particulier inférieure à 300°C, de préférence inférieure à 250°C.

4. Procédé selon l'une des revendications 1 ou 2, **caractérisé en ce que** l'on chauffe le matériau de liaison (7) localement, en particulier au moyen d'un faisceau laser (13), de préférence au moyen d'au moins un scanner laser, de préférence à une température de frittage inférieure à 250°C.

5. Procédé selon l'une quelconque des revendications précédentes, **caractérisé en ce que** l'on effectue le dépôt du matériau de liaison (7) et/ou la mise en contact des tranches (1, 2, 14) et/ou le frittage sous vide.

6. Procédé selon l'une quelconque des revendications précédentes, **caractérisé en ce que** les tranches (1, 2, 14) sont métallisées, au moins dans la future région de contact avec le matériau de liaison (7), de préférence sous la forme de cadres de liaison (5), avant le dépôt du matériau de liaison (7).

7. Procédé selon l'une quelconque des revendications précédentes, **caractérisé en ce que** l'on utilise un matériau de liaison (7), qui comprend des particules d'argent, de préférence avec une valeur d₅₀ inférieure à 300 nm, en particulier avec une taille maximale de particules de moins de 250 nm, de préférence inférieure à 200 nm, en particulier de préférence inférieure à 100 nm, et de préférence encore inférieure à 50 nm.

8. Procédé selon l'une quelconque des revendications précédentes, **caractérisé en ce qu'**au moins une substance d'addition, en particulier une matière organique, est mélangée aux particules d'argent.

9. Procédé selon l'une quelconque des revendications précédentes, **caractérisé en ce que** l'on utilise un matériau de liaison (7) pâteux et/ou pulvérulent.

10. Procédé selon l'une quelconque des revendications précédentes, **caractérisé en ce que** l'on dépose le matériau de liaison (7) par impression au pochoir, par sérigraphie, par pulvérisation ou par étalement.

11. Procédé selon l'une quelconque des revendications précédentes, **caractérisé en ce qu'**on lie l'une à l'autre par frittage plus de deux tranches en une pile de tranches (10).

12. Procédé selon l'une quelconque des revendications précédentes, **caractérisé en ce que** l'on divise, en particulier on coupe au faisceau laser ou on scie, les tranches assemblées (1, 2, 14) en puces coiffées individuelles, en particulier de puces de détecteur micromécaniques, ou en piles de puces.

13. Tranche composite, en particulier fabriquée par un procédé selon l'une quelconque des revendications précédentes, comprenant au moins deux tranches (1, 2, 14) assemblées l'une à l'autre, dans laquelle les tranches (1, 2, 14) sont fixées l'une à l'autre par un matériau de liaison fritté (7) disposé entre les tranches, **caractérisée en ce que** le matériau de liaison (7) se trouve sur un cadre de liaison (5) autour d'un circuit (6) formé sur au moins une des tranches (1, 2, 14).

14. Puce, en particulier puce de détecteur, de préférence fabriquée par un procédé selon l'une quelconque des revendications 1 à 12, comprenant au moins deux plans de matériau de tranche, dans laquelle les plans de matériau de tranche sont fixés l'un à l'autre par un matériau de liaison fritté (7) disposé entre les plans de matériau de tranche, **caractérisée en ce que** le matériau de liaison (7) se trouve sur un cadre de liaison (5) autour d'un circuit (6) formé sur au moins un des plans de matériau de tranche.
